(19) Europäisches Patentamt
European Patent Office
Office européen des brevets

(11) EP 0 451 642 B1

## (12) EUROPEAN PATENT SPECIFICATION

(45) Date of publication and mention
of the grant of the patent:
**21.08.1996  Bulletin 1996/34**

(51) Int Cl.6: **H01J 37/34**

(21) Application number: **91105035.9**

(22) Date of filing: **28.03.1991**

(54) **Sputtering system**

Zerstäubungssystem

Système de pulvérisation

(84) Designated Contracting States:
**BE CH DE ES FR GB IT LI NL**

(30) Priority: **30.03.1990  US 502391**
**23.04.1990  US 512719**

(43) Date of publication of application:
**16.10.1991  Bulletin 1991/42**

(73) Proprietor: **APPLIED MATERIALS, INC.**
**Santa Clara California 95054-3299 (US)**

(72) Inventors:
• **Tepman, Avi**
**Cupertino, CA 95014 (US)**

• **Parker, Norman William**
**Fairfield, CA 94533 (US)**

(74) Representative: **Diehl, Hermann O. Th., Dr. et al**
**Diehl, Glaeser, Hiltl & Partner**
**Patentanwälte**
**Postfach 19 03 65**
**80603 München (DE)**

(56) References cited:
**EP-A- 0 211 412          EP-A- 0 248 244**
**EP-A- 0 365 249**

## Description

Preliminary Remarks

In the figures, the first digit of a 2 or 3 digit reference numeral indicates the first figure in which is presented the element indicated by that reference numeral and the first two digits of a 4 digit reference numeral indicates the first figure in which is presented the element indicated by that reference numeral.

Description

This invention relates in general to sputtering deposition and relates more particularly to a sputtering system for sputtering particles from a target onto a wafer.

In a sputtering device, a target is subjected to bombardment by high energy ions to dislodge and eject material from the target onto a workpiece, such as a semiconductor wafer. In general, the target and wafer are placed into a vacuum chamber that is evacuated to a pressure typically on the order of or less than $3. 10^{-4}$ Torr 1 Torr = 1.333 mbar. In physical sputtering, the bombarding particles are generally ions of a heavy, inert gas such as argon and are accelerated to high velocities in directions that are substantially perpendicular to an exposed front surface of the target.

For industrially acceptable sputtering rates, it is important to produce a relatively high density of ionized bombarding particles. The most cost-effective source of ions is a low pressure glow discharge. In electrically biased glow discharge sputtering devices, the wafer is mounted on a pedestal that is biased as the sputtering reactor anode or separate anode and the target is biased as the sputtering reactor cathode. This produces at the target an electric field that is substantially perpendicular to the exposed front surface of the target and that accelerates the ions into the exposed surface of the target along trajectories that are substantially perpendicular to the front surface of the target.

Collisions between high energy electrons and gas molecules ionize some of these neutral particles to replace the ions that bombard the target. This ionization produces within the reactor chamber a conductive plasma body that is separated from the cathode and anode by free-electron deficient regions called plasma sheaths. Because the plasma body is conductive, the accelerating electric fields are substantially restricted to the plasma sheath regions at the wafer and target.

In a planar magnetron sputtering device, ion densities at the target are enhanced by producing within the target sheath a magnetic field that helps trap and direct electrons near the target. The increased electron density in these traps increases the rate of ion generation within these regions, thereby increasing the ion density at portions of the target that are adjacent to these trap regions. Because the electric field $\vec{E}$ within the target sheath is substantially perpendicular to the exposed surface of the target, in those regions where the magnetic field $\vec{B}$ is substantially parallel to the target surface, the $\vec{E} \times \vec{B}$ drift field pushes electrons parallel to the surface of the target. The electrons are trapped by configuring the magnetic fields so that these regions in which the $\vec{E} \times \vec{B}$ drift field is parallel to the target surface form closed paths within which the electrons are then trapped. This configuration of the drift fields is achieved by cooperative selection of the locations and shapes of magnetic fields.

Typically, the target material is attached to a backing plate that is mounted within the reactor. It is important that sputtering of the target does not reach this backing plate because particles sputtered from the backing plate would contaminate the integrated fabrication process. Therefore, a target is typically replaced before sputtering of the backing plate can possibly happen. Unfortunately, this results in the replacement of targets that still contain a significant fraction of the original target material.

Because many targets are composed of an expensive material, such as gold, and because of the significant expense of lost production time to replace a target, it is important to maximize the amount of sputtering that is allowed before the target must be replaced. In German Offenlegungsschrift **27 07 144** entitled *Kathodenzerstaeubungsvorrichtung* filed by Sloan Technology Corp on February 18, 1977, magnet/magnetic pole assemblies are swept either longitudinally in x- and y- directions or off-axis pole assemblies are swept radially about a rotation axis to produce a pattern of target sputter that has an increased time-averaged uniformity of sputter from the target.

In U.S. patent **4,444,643** entitled *Planar Magnetron Sputtering Device* issued to Charles B. Garrett on April 24, 1984, a movable magnetic field source is moved parallel to the face of the target to produce a time-averaged sputter of the target that has increased uniformity over the target, thereby increasing the number of wafers that can be processed through use of a single target.

In U.S. patent **4,714,536** entitled *Planar Magnetron Sputtering Device With Combined Circumferential And Radial Movement Of Magnetic Fields* issued to Kenneth F. Freeman et al on December 22,1987, it is asserted that, in such prior devices, a fixed point on the magnet assembly always rotates over a given radial position on the target, so that circular grooves tend to be formed. To produce a more uniform sputter of the target, the magnetic field is moved in and out radially as it is rotated off-axis about the center of the target.

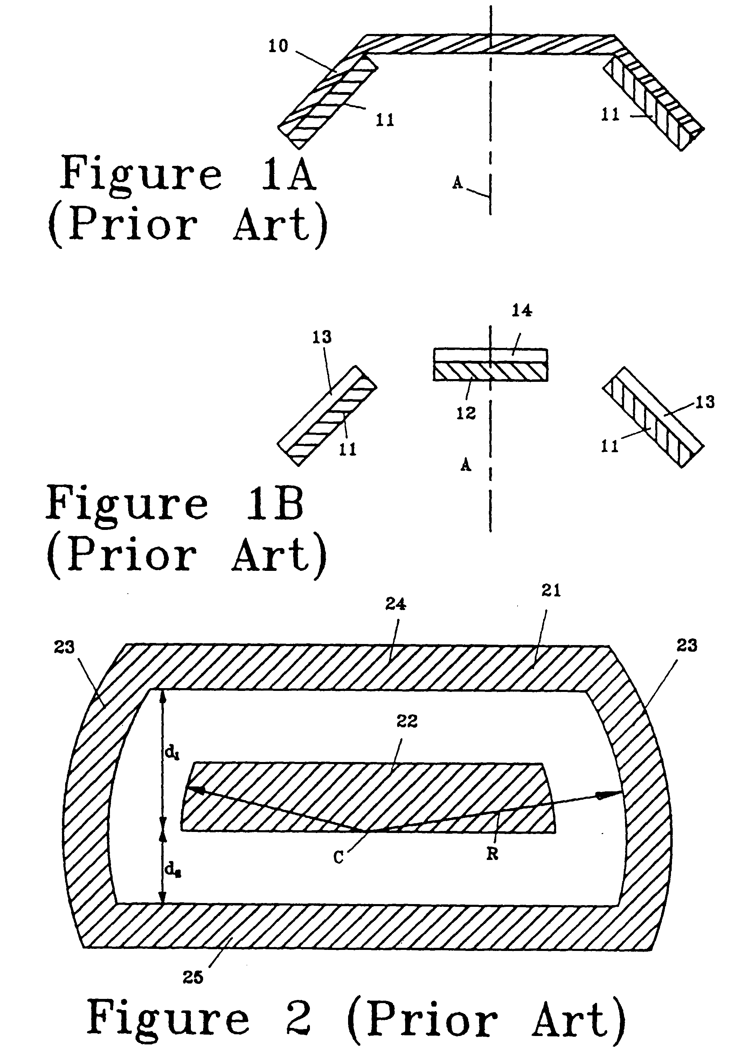

Although there are clear cost benefits to improving the efficiency of utilization of a target, it is also important to produce wafer coatings that have very uniform thickness. Figures 1A and 1B illustrate the CONMAG I and CONMAG II systems, respectively, from Varian Associates which each includes on a metal support 10 a conical target 11 to improve step coverage and uniformity. A single power supply is connected between support 10 and the wafer pedestal. In the CONMAG II embodiment, a second target 12 is included that is centered on and perpendicular to the axis A of conical target 11. There is no rotation of either of these targets. Conical target 11 is mounted on a conical metal support 13 and target 12 is mounted on a separate metal support 14. Separate power supplies are provided to each of these two metal supports so that two plasma regions can be produced. In the CONMAG II embodiment, the addition of target 12 and separate metal support 14 requires that the spacing between targets 11 and 12 be nonoptimal, so that the uniformity of coating from these two targets is reduced.

In a 1000 Series sputtering system by Anelva, a wide single groove is produced in the target by means of a pair of magnetic pole pieces 21 and 22 having the shapes indicated in Figure 2. The sides of the outer magnetic pole piece 21 have a radius of curvature R centered on a point C. The top side 24 and the bottom side 25 are straight and are vertically separated from point C by distances $d_1$ and $d_2$ respectively. The inner magnetic pole piece 22 has a perimeter having substantially the same shape as the outer pole piece. The magnetic field is produced by these two pole pieces.

There are a number of problems with the above references. In U.S. patent **4,714,536,** the gears that generate the combined rotational and radial movement are located in the cooling water for this target. Because of the lack of lubrication of these gears, these gears corrode quickly, requiring very frequent replacement. Also, the plasma sheath is relatively short so that at any given moment there is sputter deposition on only a small portion of the substrate.

In German Offenlegungsschrift **27 07 144,** in U.S. patent **4,444,643,** and in U.S. patent **4,714,536,** the efficiency of target utilization is increased, but without any concern for the effect on the quality of sputtered coating produced on the wafer. Especially in submicron integrated circuit fabrication, it is very important to produce layers having uniform thickness and excellent step coverage. When a layer is patterned, if portions of the layer are thicker than other portions, then each of these portions will achieve pattern completion at different times. If some regions are over-etched to achieve etch completion in other regions, then linewidths in the over-etched regions will be reduced below designed values. The layer uniformity and step coverage of these systems are therefore inadequate for most sputtering applications in current state of the art circuits. Thickness variations on the order of 25% can result from the above-discussed process, making it suitable substantially only for deposition of the back ground plane of the wafer.

Uniform coatings are also important for preserving accurate mask alignment. The alignment marks typically consist of raised features on a wafer so that they remain visible even after deposition of several layers on the wafer. Asymmetric coating at alignment marks can produce spurious results in the apparent location of these marks, thereby misaligning subsequent patterning.

In the Anelva sputtering system, good layer thickness uniformity (on the order of 3% variation in thickness) can be achieved by-positioning the target at a greater distance (on the order of 80 mm) from the wafer that is typical (i.e., on the order to 40-50 mm). Unfortunately, at this spacing, this system produces poor step coverage because there is not enough deposition from wide angle incident sputtered particles.

The European patent applications EP-A-0 211 412, EP-A-0 248 244, and EP-A-0 365 249 all tackle the problem of uniformity of deposition on a substrate and erosion of a target by employing patterns of permanent magnets mounted to a base plate and rotating these arrangements eccentrically relative to the center of the opposed target. EP-A-0 211 412 uses preferably a heart shaped, symmetrical arrangement, while EP-A-0 248 244 shows symmetrical rings, ellipses and intersecting parts thereof. EP-A-0 365 249, which was published on April 25, 1990, and shall only be considered with respect to novelty, has an asymmetric arrangement of an inner permanent magnet group and an outer permanent magnet group, mounted on a common yoke.

The invention therefore attacks the problems of thickness uniformity and step coverage of coats produced by planar magnetron sputtering. Accordingly, the invention provides a sputtering system according to independent claim 1. Further advantageous features and details of the invention are evident from the dependent claims, the description and the drawings. The claims are intended to understood as a first non-limiting approach of defining the invention in general terms.

The invention provides a planar magnetron sputtering source producing improved coating thickness uniformity, step coverage and step coverage uniformity.

In accordance with the illustrated preferred embodiment, a planar magnetron sputtering system is presented in which the shapes of a pair of pole pieces produces excellent coating uniformity, excellent step coverage and excellent step coverage uniformity. The shapes of these pole pieces in a cross-section parallel to the surface of the target is motivated by an analysis of the angular distribution of sputtered particles as they leave the target and an analysis of the distribution of sputtered particles needed to produce uniform coatings, excellent step coverage and excellent step coverage uniformity. In one class of embodiments, the shape of these pole pieces in a cross-section perpendicular to the surface of the target is motivated by both target utilization efficiency and the uniformity of coating thickness, step coverage and step coverage uniformity.

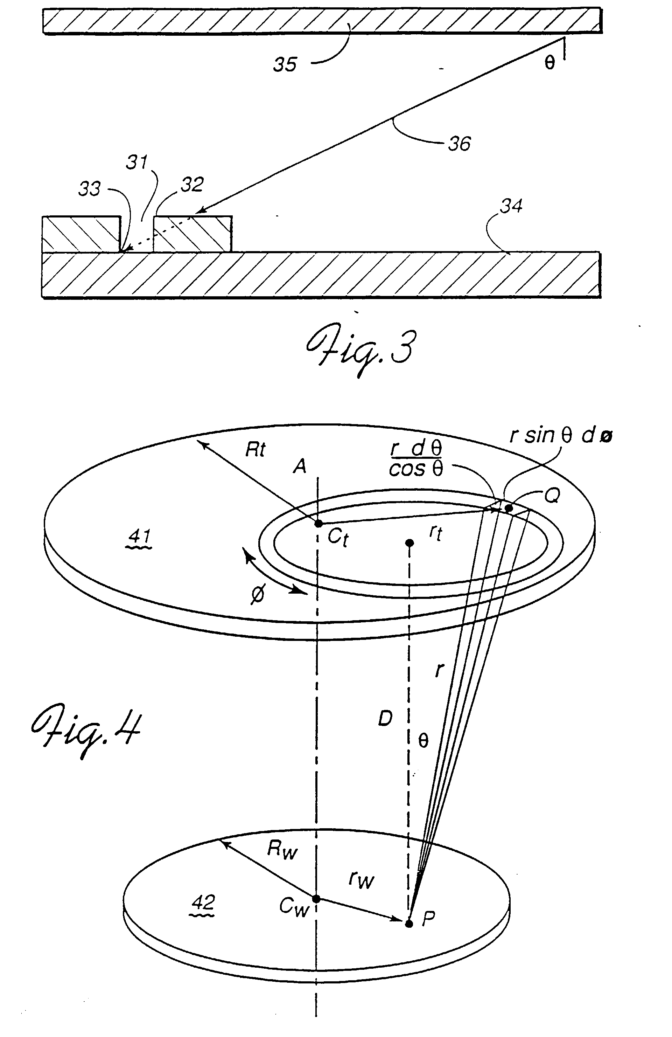

In Figure 3, the path of a sputtered particle 36 from a target 35 to a wafer 34 is illustrated. In particular, this path illustrates the effect of the angle of incidence of this particle at a hole 31. If incident particles arrive at hole 31 at to oblique an angle $\theta$, then the top corner 32 of one sidewall of this hole can shadow the base 33 of the opposite sidewall of this hole. Thus, for a hole of width W and depth D, only the particles arriving from angles $\theta$ in the range from zero to arctan W/D are effective in producing a coating on the left sidewall. Similarly, only the particles arriving from angles $\theta$ in the range from zero to arctan W/D are effective in producing a coating on the right sidewall. Excellent step coverage requires that, over the entire wafer, there is a sufficient flux of particles from both sides of a hole, trench or line that both sides of such feature will be coated. Excellent step coverage uniformity requires that, throughout the top surface of the wafer, there is approximately the same flux from each side of every hole, trench and line and that the ratio between the average thickness on flat surfaces to the average thickness on sidewalls is a reasonably small number on the order of 5 or less.

In physical sputtering (as opposed to chemical sputtering) it is theorized that the incident bombarding particles produce within the target a collisional cascade having a statistical distribution of momentum directions. This statistical process ejects target particles in random directions so that there is a substantially cosine angular distribution of ejection of particles from the target. Empirical tests show that this distribution does indeed result for a sputtering potential on the order of 2000 eV and that for larger sputtering potentials this distribution skews somewhat toward directions more parallel to the target surface.

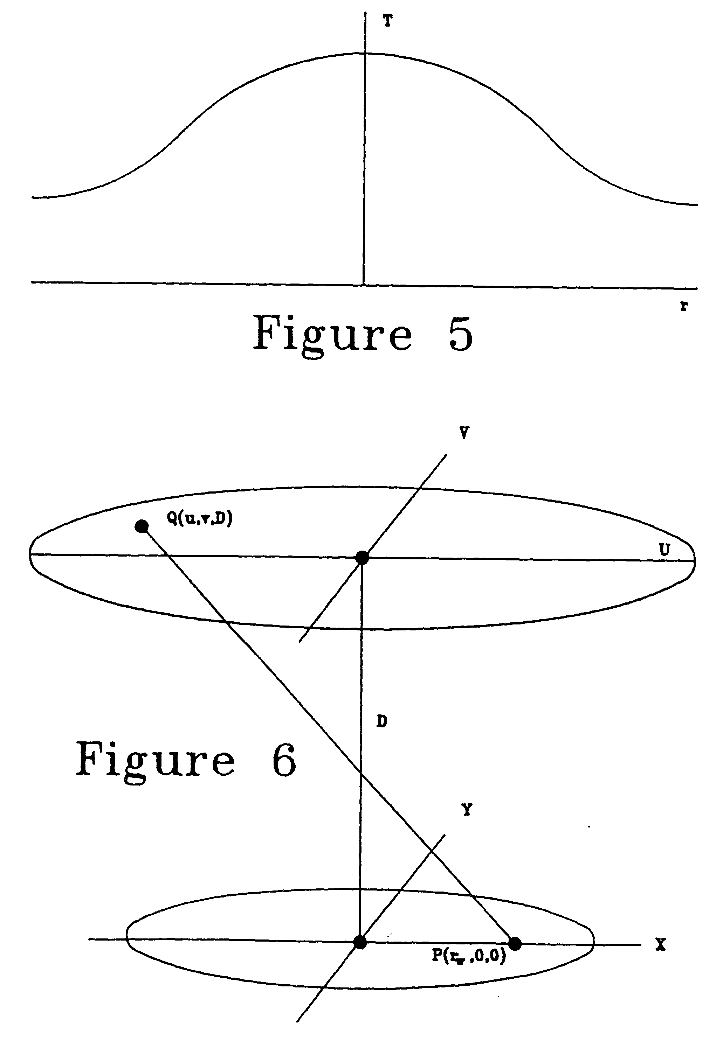

As illustrated in Figure 4, at a point P of a wafer 42, the intensity $I(P,\theta,\phi)$ of particles incident within a solid angle $d\theta d\phi$ centered at the angular polar coordinates $\theta,\phi$ is substantially equal to the product of the following factors: (1) the area $r^2 \cdot \tan\theta \cdot d\theta d\phi$ of the portion of the target within the angular ranges $d\theta$ and $d\phi$; (2) the $r^{-2}$ factor of decrease in intensity for a spherically symmetric distribution of flux; (3) the $\cos(\theta)$ projection factor to account for the angle $\theta$ between the normal to the wafer and the incident flux vector for these particles; and (4) the rate S of sputtering from this infinitesimal area of the target, determined by the time-averaged local plasma intensity. Thus, if the effects of gas scattering are neglected, then the intensity of particles incident on point P, within this solid angle, is:

$$I(P,\theta,\phi,) = S(Q) \cdot \sin\theta \cdot d\theta d\phi \qquad (1)$$

where Q is the point of the target from which the sputtering produces these incident particles.

When S(Q) is substantially constant, as is the objective of those prior art patents discussed above that seek to maximize the use of the target, this flux at point P is just the solid angle subtended at point P of the wafer by this infinitessimal area of the target. Therefore, for these devices, the total intensity $I(P) = \int I(P,\theta,\phi) d\theta d\phi$ of particles on a point P of the wafer is equal to the solid angle subtended at point P by the target. In general, the wafer is centered under and is parallel to the target so that the maximum subtended solid angle occurs when point P is located at the center of the wafer. Therefore, these prior sputtering systems produce a coating thickness that is definitely not uniform over the wafer. Because of the axial symmetry of the wafer/target system, the thickness T is a function only of the radial distance $r_w$ of point P from the center $C_w$ of the wafer and has the shape illustrated in Figure 5.

Because the target has a finite radius $R_t$, for any given angle $\phi$ about the vertical line through point P, there is a maximum value of azimuthal angle $\theta$ for which the flux is nonzero. For larger values of $\theta$, the cone of solid angle $d\theta d\phi$ in the direction $\theta,\phi$ does not intersect the target so that no particles can be sputtered from this direction. Therefore, the angular distribution of particles at a point P is a function of the distance of point P from axis A, the radius $R_t$ of the target, the radius $R_w$ of the wafer, the distance D between the wafer and the target, and the sputtering intensity distribution within the target. For a spatially uniform sputter rate from the target, the rate of sputter deposition onto point P from the direction of axis A will increase with the distance of point P from axis A and the rate of sputter from the direction of the closest point on the perimeter of the target will decrease with the distance of point P from axis A. Therefore, prior systems that produce uniform sputtering of the target will have poor step coverage uniformity.

Because of the axial symmetry of the system about an axis A that passes through the centers $C_t$ of the target and $C_w$ of the wafer, the deposited intensity $I(P,\theta,\phi)$ will retain axial symmetry only if S is a function only of the radial distance $r_t$ from the center $C_t$ of the target. That is, $S = S(r_t)$ and is zero for $r_t$ greater than the radius $R_t$ of the target. For this choice, at the point P located at the radial distance $r_w$ from the center of the wafer, the total intensity I(P) is independent of the angular position $\phi_w$ (about axis A) of point P and is therefore a function only of $r_w$. Mathematically, $I(r_w)$ is the integral over all $\theta$ and $\phi$, where, for each value of $\theta$ and $\phi$, point Q is located to produce incident particles in this direction. Because of the rotational symmetry, this can be evaluated for the special case of a point on the wafer at $x = r_w$ and $y = 0$, as illustrated in Figure 6:

$$I(r_w) = \int_\Gamma [S(\{u^2 + v^2\}^{\frac{1}{2}}) \cdot D \cdot \{(r_w-u)^2 + v^2 + D^2\}^{-3/2}] du dv \qquad (2)$$

where D is the spacing between the wafer and the target, $\int_\Gamma$ represents the integral over the (u,v) range within the target, and $S(\{u^2 + v^2\}^{\frac{1}{2}})$ is zero for $\{u^2 + v^2\}^{\frac{1}{2}}$ greater than the target radius $R_t$. The integrand is the product of the sputtering intensity distribution (i.e., the distribution of the rate of sputtering particles from the target) at point (u,v,D), the cosine of the angle between the normal to the wafer and the vector connecting points (u,v,D) and $(r_w,0,0)$, and the $r^{-2}$ factor characteristic of a spherically symmetric flux.

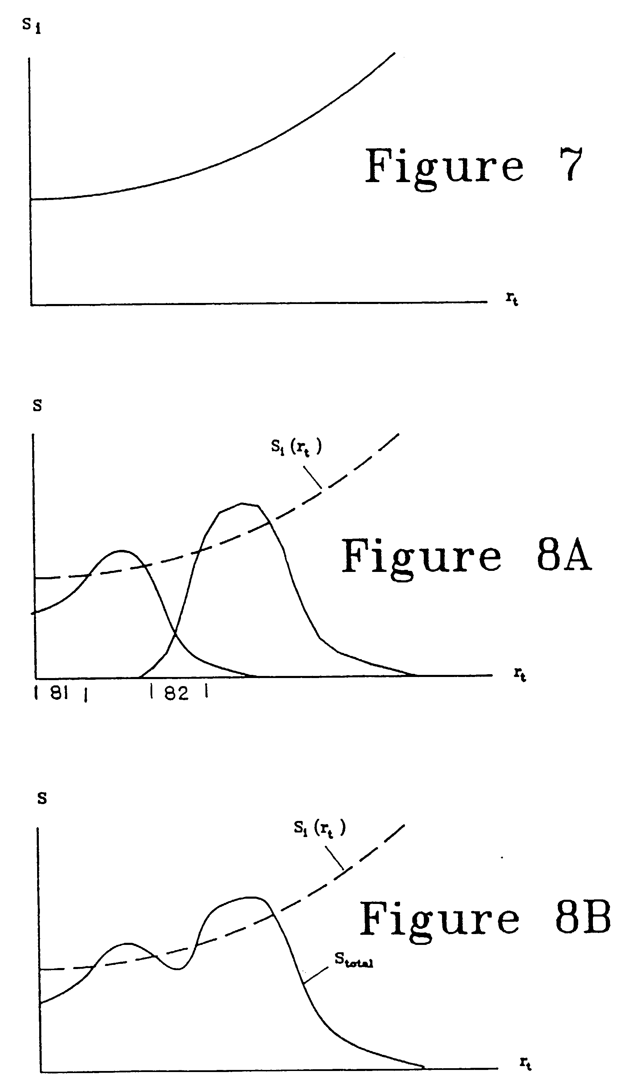

To produce a substantially uniform coating thickness on the wafer, $S(r_t)$ must have the ideal functional dependence $S_I(r_t)$ as illustrated in Figure 7. This sputtering profile can be approximated by etching in the target a set of N axially symmetric grooves, where the kth groove produces a sputtering intensity distribution $S_k(r_t)$ and the total actual sputtering rate $S_a(r_t)$ is:

$$S_a(r_t) = \sum_{k=1}^{N} S_k(r_t) \qquad (3)$$

This is illustrated graphically in Figures 8A and 8B for the case N = 2. Figure 8A shows the sputtering intensity distribution for each of the two grooves and Figure 8B compares the total actual sputtering intensity distribution with the ideal sputtering intensity distribution, illustrating that a reasonable approximation to the ideal distribution can indeed be produced sputtering a pair of concentric circular grooves into the target of appropriate radius, width and depth.

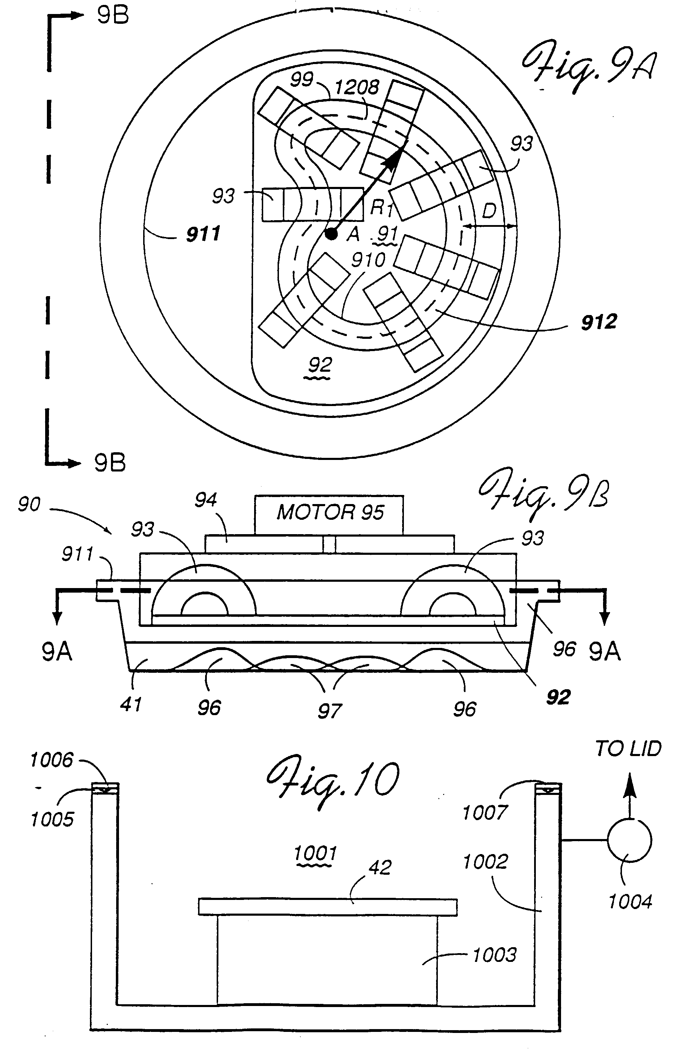

The formation of selected grooves in the target is achieved by means of a specially designed magnetron source having pole pieces that produce the sputtering intensity $S_a(r_t)$. Pole pieces that achieve this actual sputtering profile for N = 2 are illustrated in Figure 9A. This design is easily adapted for other values of N.

This design utilizes the facts that, in a magnetron sputtering system, the majority of sputtering occurs where the magnetic field is approximately parallel to the target and that the regions where this occurs must form closed paths within which electrons can be trapped to enhance ion generation and the associated local sputtering rate. The pole pieces and magnets are rotated about a central axis A of the target to produce a circularly symmetric sputtered pattern of grooves in the target.

The regions where the magnetic field is substantially parallel to the target occur along a track between the two pole pieces. The pole pieces are designed so that this track consists of three regions: (1) a first approximately circular arc of radius $R_1$ centered on axis A; (2) a second approximately circular arc of radius $R_2$ centered on axis A; and (3) two sections that couple the first and second arcs to form a closed path. At axis A, the first arc subtends an angle $\alpha_1$ and the second arc subtends an angle $\alpha_2$. As these pole pieces are rotated about axis A, 2 grooves of radius $R_1$ and $R_2$ are produced having a relative depth of $\alpha_1/\alpha_2$. The sections of the track that connect these two arcs produce sputtering of the region between these two grooves, thereby flattening the sputtered region between these two grooves. The arc lengths and radii of the first and second sections of the track are selected to optimize the flatness of coating thickness sputtered from the target onto a wafer.

Excellent step coverage requires adequate thickness of coverage over the entire step and sufficient sputter deposition onto both sidewalls of a line, trough or hole that both sidewalls are adequately coated. Excellent step coverage uniformity requires substantial equality of coverage of both upward and downward steps so that asymmetric coverage of a step does not result. Asymmetric coverage of alignment marks can produce misalignment of subsequent layers. Asymmetric coverage of underlying features can produce misalignment of those features with features in subsequent layers. The monotonically increasing form of the sputtering rate $S(r_t)$ increases the fraction of particles obliquely incident on point P in directions toward the center of the wafer, thereby improving step coverage uniformity. The uniformity of step coverage is also a function of the ratio $R_t/R_w$ between the target radius $R_t$ and the wafer radius $R_w$. This ratio and the sputtering rate $S(r_t)$ can be selected to achieve excellent step coverage uniformity and excellent coating thickness uniformity.

Because the rotation axis A is within the boundaries of these poles, the area covered by these poles at any given instant is a substantial fraction of the area of the target. This produces a much greater sputtering rate than is produced by the systems of **U.S. patent 4,714,536** and **German Offenlegungsschrift 27 07 144** in which sputtering occurs from only a small fraction of the target at any given instant. Because there is a single trap region track produced, there is no instability as to which of multiple possible plasma regions actually produce a plasma, as is the case in CONMAG II discussed above. This instability occurs because of the nonlinear nature of the plasma. If one part of the plasma produces an extra amount of ionization, it will produce an increased conductivity that draws more current into that region, producing even more ionization. Thus, this single trap region avoids the need for a separate power source for each trap region, as is required in CONMAG II discussed above.

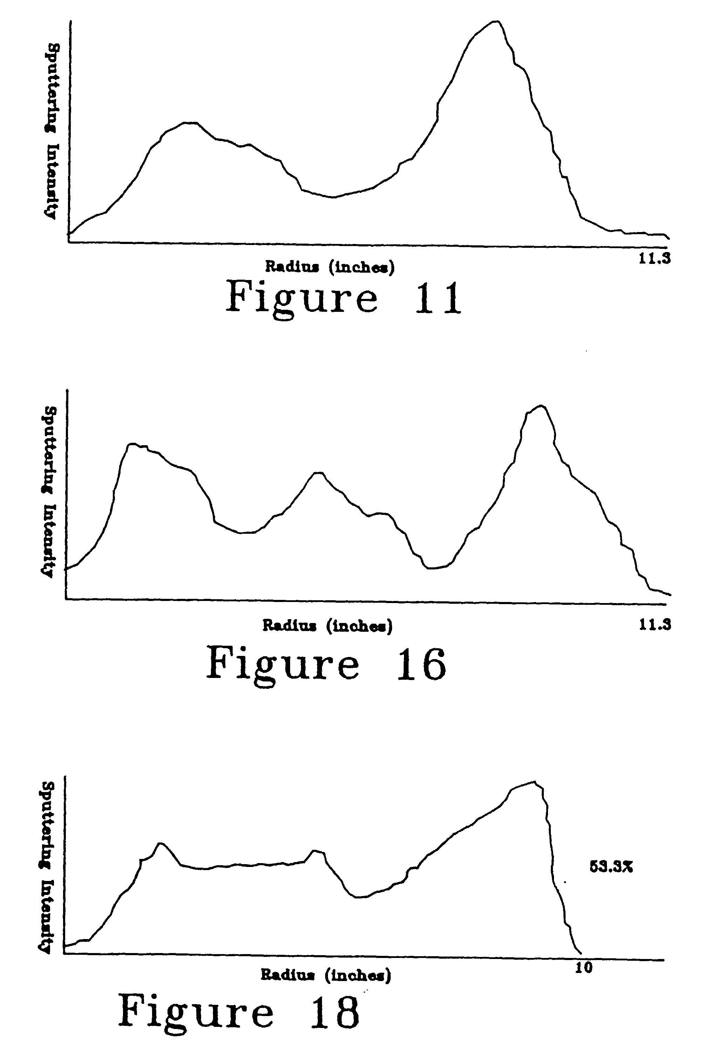

In one embodiment, the magnetic field is produced by a set of horseshoe magnets, each of which has a first polarity pole attached to a first pole piece and having its opposite polarity pole attached to a second pole piece. In the gap between these pole pieces, a trap region is produced by the magnetic field between the pole pieces and the electric field that accelerates ions into the target. These pole pieces are rotated about an axis A that is perpendicular to the target and to a plane containing the pole pieces so that a cylindrically symmetric sputter pattern is produced in the target. This particular shape produces a sputter intensity pattern having a pair of peaks analogous to the peaks illustrated in Figures 8A and 8B. The measured distribution of the actual depth of sputter from the target is illustrated in Figure 11.

In an alternate embodiment, a first pole piece is substantially planar and a second pole piece has a U-shaped cross-section in a plane perpendicular to the plane of the first pole piece. This embodiment enables substantial sputtering much closer to the outer boundary of the target, thereby improving the amount of target utilization. Because an unsputtered band of width W at radius r represents an area approximately equal to $2\pi rW$, the ability to sputter out to an increased maximal value of r results in a significant increase in the fractional usage of the target. This embodiment also enables an increased strength of magnetic field between the pole pieces because an increased amount of magnetic material can be packed within the magnetron assembly.

These and other objectives and advantages of the present invention will become clear from the detailed description given below in which a preferred embodiment is described in relation to the drawings. The detailed description is presented to illustrate the present invention, but is not intended to limit it.

## Description of the Figures

Figures 1A and 1B illustrate the CONMAG I and CONMAG II systems, respectively, from Varian Associates, that includes a conical target to improve coating uniformity and step coverage.

Figure 2 illustrates a sputtering system by Anelva, in which a wide single groove is produced in the target by means of a pair of magnetic pole pieces that are rotated about center point C.

Figure 3 illustrates shadowing that can occur for highly oblique incident particles.

Figure 4 illustrates the factors that determine the angular distribution of sputtered particles onto a wafer.

Figure 5 illustrates the radial distribution of sputter-deposited particles on a wafer when the target is substantially uniformly sputtered.

Figure 6 illustrates the calculation of the total flux at a point P of the wafer at a radius $r_w$.

Figure 7 illustrates the ideal radial dependence on sputter intensity needed to achieve a substantially uniform sputter deposited coating thickness.

Figures 8A and 8B illustrate the approximation of the ideal radial dependence of sputtering achieved by sputtering a pair of grooves of controlled depth, width and location.

Figures 9A and 9B are top and side views of a magnetron assembly having pole pieces that produce excellent sputter deposited coating thickness uniformity, excellent step coverage and excellent step coverage uniformity.

Figure 10 illustrates a sputtering system utilizing the magnetron assembly of Figures 9A and 9B.

Figure 11 illustrates the actual two peak sputter distribution that results from the pole pieces illustrated in Figure 9A.

Figures 12A-12C illustrate the evolution from a two track sputtering system to that of Figures 9A and 9B.

Figure 13 illustrates the portion of a sputtered groove that produces a radially inward flux of particles on a point P of the wafer.

Figure 14 illustrates a particular embodiment of the pole pieces in which the track is formed by milling a metal sheet with a constant width closed cut consisting of four circular arcs.

Figure 15A is a top cross-sectional view of a magnetron in which the shapes of a pair of pole pieces extend the outer sputtering peak much closer to the outer perimeter of the target than is achieved by the pole pieces of the magnetron illustrated in Figure 9A.

Figure 15B is a top cross-sectional view of the magnetron of Figure 15A illustrating the locations of the magnets.

Figure 15C is a vertical cross-section of the pole pieces illustrating the structure of the outer pole piece, inner pole piece and permanent magnets.

Figure 15D is a top cross-section through a sealing plate of the pole piece/magnet assembly.

Figure 16 illustrates the actual sputtering distribution $S_a(r_t)$ produced by the system of Figures 15A and B for an 11.3" target.

Figure 17 is a view, analogous to that in Figure 9A, for an alternate embodiment of the magnetron pole pieces.

Figure 18 illustrates the actual sputtering distribution $S_a(r_t)$ produced for an 10" target by an alternate embodiment of Figure 9A that is illustrated in Figure 17.

Figures 9A and 9B respectively illustrate a top cross-sectional view and a side cross-sectional view of a magnetron assembly 90 having ferromagnetic pole pieces 91 and 92 that enable the production of sputtered coatings having uniform thickness, excellent step coverage and excellent step coverage uniformity. This magnetron assembly is utilized as the lid of a sputtering system vacuum chamber such as that in Figure 10.

A top cross-section is also referred to herein as the "parallel cross-section" because this cross-section lies in a plane that is parallel to the target. Similarly, a side cross-section is also referred to herein as the "perpendicular cross-section" because it is perpendicular to the target.

A typical sputtering system includes a vacuum chamber 1001 within which a high vacuum is produced. Chamber 1001 is typically enclosed by sidewalls 1002 and magnetron assembly 90 that also functions as the lid for the vacuum chamber. The sidewalls are often formed of a metal such as stainless steel or aluminum. Attached to the underside of the lid is a target 41 formed of a material that is to be sputtered onto a wafer 42. In the bottom of chamber 1001 is a pedestal 1003 on which the wafer is placed during processing. A voltage source 1004 produces a dc or rf potential difference between walls 1002 and magnetron assembly 90 to accelerate ions into the target to sputter target particles onto the wafer. A metal ring 1005 is attached to the top of the sidewalls and includes a groove 1006 in which is inserted a rubber O-ring. This O-ring forms a vacuum seal between metal ring 1005 and a ring 1007 formed of a nonconductive material such as teflon or a ceramic. Nonconductive ring 1006 enables a voltage difference to be produced between sidewalls 1002 and magnetron assembly 90. Because of the heat generated by the impact of high energy ions on the target, a coolant system, such as water-cooled chamber 94, is thermally connected to the target. To enhance cooling of the target, a backing plate 911 within the magnetron assembly is formed of a highly heat-conductive material such as copper.

In magnetron sputtering systems, a magnetic field is produced within chamber 1001 adjacent to target 41 to increase the generation of ions near the target by trapping electrons near the target. This electron trap typically consists of one or more closed loop regions within which the magnetic field is substantially parallel to the target. In these regions, the electric field and magnetic field are substantially perpendicular and produce an $\vec{E} \times \vec{B}$ drift field that pushes electrons parallel to the surface of the target. Because these regions form closed loops, the electrons become trapped near the target, thereby effectively producing ions that impact the target. In this sputtering system, magnetron assembly 90 produces these electron trap regions.

As is illustrated in Figures 9A and 9B, magnetron assembly 90 includes pole pieces 91 and 92, magnets 93, a sealing rim 96, target 41, and a motor mounting plate 94 that couples pole pieces 91 and 92 to a motor 95. All of these magnets have the same polarity magnetic pole in contact with pole piece 91. Although electromagnets can be used to produce a magnetic field between the pole pieces, permanent magnets are preferred because of their greater field strength.

Motor 95 rotates pole pieces 91 and 92 and magnets 93 about an axis A centered over wafer pedestal 1003 to produce a time averaged sputtering pattern that is circularly symmetric. As will be discussed in greater detail below, this rotation produces in target 41 circular sputtered grooves 97 and 98 that are centered on axis A. The width, depth and spacing of these grooves relative to axis A are chosen to produce very uniform coating thicknesses on wafer 42. Because groove 98 produces a large number of oblique ions onto the entire target and these ions have all possible lateral components (i.e., all possible vector components parallel to wafer 42), excellent step coverage results throughout the wafer for all orientations of steps.

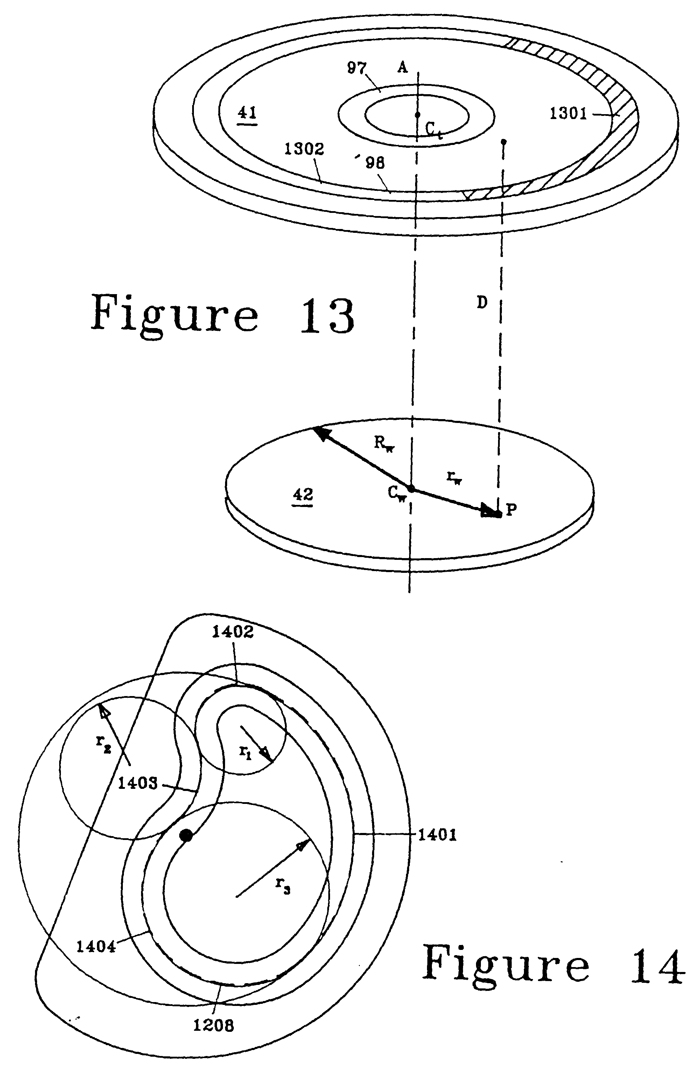

In Figure 13 it can be seen that the portion 1301 of groove 98 produces at point P a flux of ions having a radial component inward toward axis A. The portion 1302 of groove 98 and all of groove 97 produce at point P a flux of ions having a radial component outward from axis A. Because portion 1301 of groove 98 is deeper and longer than groove 97, and is closer to points P than most of groove 97 and most of portion 1302, the flux from portion 1301 can be as large as from these other sources. The radii of groove 97, groove 98, wafer 42 and target 41 are chosen in conjunction with the widths and depths of these grooves to produce substantially constant layer thickness and maximum step coating uniformity over the entire wafer. A pair of pole pieces that achieve this are illustrated in Figure 9A.

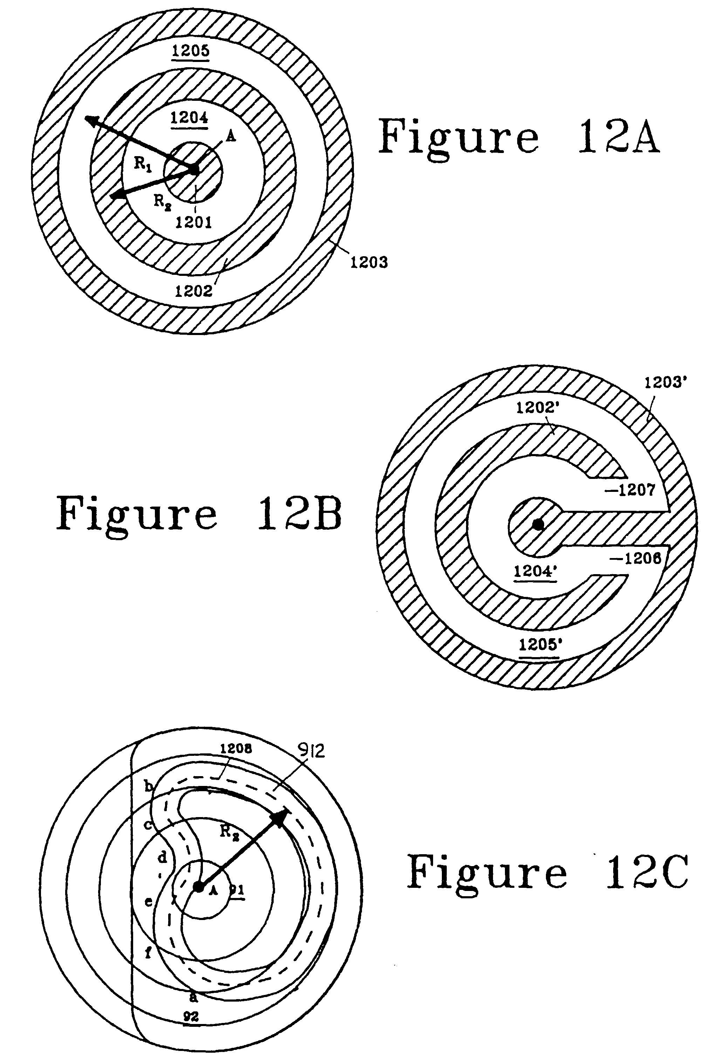

Figures 12A-12C illustrate steps utilized in deriving the pole piece shapes of Figure 9A. Figure 12A illustrates a set of three ferromagnetic pole pieces 1201-1203 that produce two gap regions 1204 and 1205 of radii $R_1$ and $R_2$, respectively. Within a band centered in each of these gap regions, the magnetic field will be substantially parallel to target 41 so that each of these regions can function as an electron trap. However, because of the nonlinearity of the plasma process, a plasma generally will result in only one of these tracks. To avoid this, the pole pieces are reshaped to form a single track that includes a portion 1204' of the arc at radius $R_1$, a portion 1205' of the arc at radius $R_2$ and a pair of radial sections 1206 and 1207 that connect these two arcs to form a closed path. The set of pole pieces now consist of a C-shaped pole piece 1202' and a pole piece 1203' that includes circular pole piece 1201, annular pole piece 1203 and a radial segment connecting these two prior pole pieces.

Empirical variation of pole pieces 1202' and 1203' resulted in pole pieces 91 and 92 of Figure 9A. Pole piece 91 is kidney shaped and pole piece 92 has an inner edge 99 that is substantially parallel to an outer edge 910 of pole piece 91 so that a gap 912 between these two edges has a substantially constant width. The constant width of this gap makes the magnetic field substantially constant throughout the length of gap 912, thereby reducing the tendency of the plasma to form only near a portion of the gap between pole pieces 1202' and 1203'.

Figure 12C compares the pole piece sets of Figures 9A and 12A to illustrate that pole pieces 91 and 92 produce a gap 912 that includes portions that are substantially at distances $R_1$ and $R_2$, respectively, from rotation axis A. The portion of gap 912 from point **a** to point **b** is substantially the same as about 50% of gap 1205 and sputters from the target an annular groove of radius $R_1$. If this portion is slightly off center from rotation axis A, it has the effect of widening the groove etched into the target. The width of the groove is also affected by the width of gap 1205. The depth of the groove can be varied by altering the magnitude that this arc subtends at axis A.

The portions of gap 912 from point **c** to point **d** and from point **e** to point **f** are substantially the same as about 15% of gap 1204. The portions of gap 912 from point **b** to point **c** and from point **f** to point a produce sputtering of the target annular region directly under pole piece 1202 of Figure 12A. The portion of gap 912 from point d to point e produces sputtering of the circular region covered by pole piece 1201 of Figure 12A.

The electrons are trapped within a track (represented by dashed line 1208 in Figures 12 and 14) that is located adjacent to the center of gap 912. The width of gap 912 is substantially constant so that the electron trapping properties are substantially constant around the entire electron trap region. In Figure 9A it can be seen that gap 912 covers rotation axis A so that sputtering of the target occurs at the center of the target as well. This increases the sputtering intensity in regions 81 and 82 of Figure 8, producing a sputtering distribution substantially equal to $S_i(r_t)$, It is important to provide at least some sputtering at all points of the target to avoid the formation of thin backsputtered regions that flake off and produce particulates that can deposit on the wafer.

The particular embodiment of Figures 9A and 12C has a gap formed from 4 sections 1401-1404 (shown in Figure 14), each of which is an arc of a circle. This results in an easily manufacturable gap that can be cut by a programmable machine tool programmed to mill sequentially the four successive circular arcs of radii $R_1, r_1, r_2$ and $r_3$, where $R_1$ is the same as shown in Figure 9A. This produces a constant width gap and produces both edges 99 and 910 (shown in Figure 9). The radii $r_1$, $r_2$ and $r_3$ and the respective arclengths of these arcs are chosen so that the portion of track 1208 between points d and e is substantially at the distance $R_2$ from rotation axis A. Radius $r_1$ is chosen smaller than $r_3$ to produce the portion of track 1208 from point b to point c to sputter the lower portion of region 82. Similarly, radius $r_2$ is chosen to produce the portion of track 1208 from point f to a such that it produces additional sputtering of the upper portion of region 82.

The uniformity of the coating thickness is measured as the variability in thickness as a fraction of the average thickness. The parameters of the pole pieces are selected to minimize this fractional change in thickness. The step coverage is measured as follows. At a hole or trench, the minimum thickness of coating is measured along the vertical height of each of a pair of opposite side walls. The ratio of the minimum side wall thickness to the film thickness on the wafer surface is the fractional step coverage of that hole or trench. The step coverage uniformity is measured as the variability of this ratio as a fraction of the average value of this ratio.

A plot of the fraction of trap region that is located at a distance $r_t$ from rotation axis A is substantially equal to $S_i(r_t)$ so that, when the pole pieces are rotated about axis A, a circularly symmetric sputter pattern is produced that is substantially equal to $S_i(r_t)$. Equivalently, the centerline of the gap is represented mathematically by an angular function $\theta(r)$ of the radial distance r of the centerline from axis A that has two monotonic sections whose sum is equal to the fraction of trap region that is located at a distance r from rotation axis A.

Wafer diameters are typically 100, 125, 150 or 200 mm and target diameters range from 250 mm for the 100 mm diameter wafer to 325 mm for the 200 mm diameter wafer. The spacing D between the wafer and target is typically in the range 35 mm to 55 mm. For the 150 mm diameter wafers, radius $R_1$ in Figure 12A is 102 mm and radius $R_2$ is 35 mm. The relative depth of sputter in the groove of radius 102 mm is twice that in the groove of radius 35 mm.

Although the magnetron assembly 90 of Figures 9A and 9B produces excellent coating thickness uniformity, step coverage and step coverage uniformity, the thickness T of the horseshoe magnets forces the distance D (illustrated in Figure 9A) of closest approach of track 1208 to a sidewall 912 of the magnetron to be greater than T.

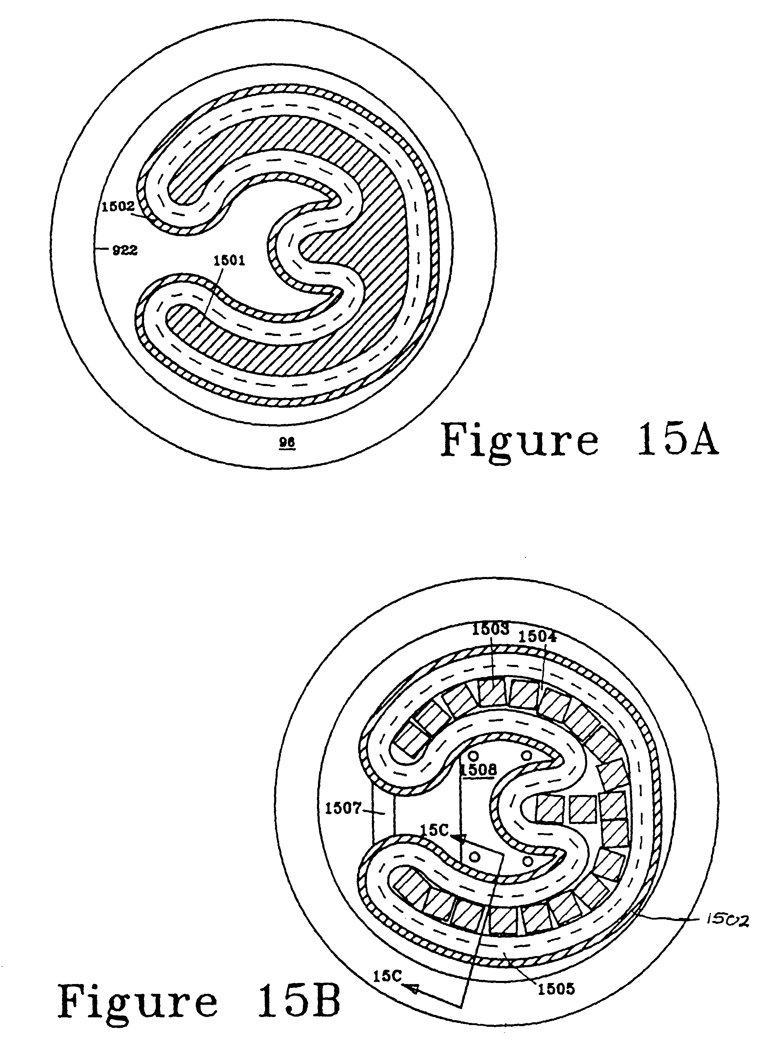

An alternate embodiment of magnetron assembly 90 is illustrated in Figures 15A-15D. The electrons are trapped within an electron trap (indicated by the dashed centerline) that is located within a gap formed between the two pole pieces 1501 and 1502. The width of the gap is substantially constant so that the electron trapping properties are substantially constant around the entire electron trap region. In Figure 15A it can be seen that the gap covers rotation axis A so that sputtering of the target occurs at the center of the target as well. This increases the sputtering intensity in region 81 of Figure 8. The actual sputtering distribution $S_a(r_t)$ produced by the system of Figures 15A-15D and 10 is illustrated in Figure 12. It should be noted that some sputtering occurs at all points of the target. This is important for avoiding the formation of thin backsputtered regions that flake off and produce particulates that can deposit on the wafer.

The ability to produce the pole piece cross-section illustrated in Figure 15A is provided by the overall structure of the pole pieces and magnets. This structure is illustrated in Figures 15A-15D. Figure 15B is a parallel cross-section that intersects magnetron 90 at an elevation that passes through the magnets. This view illustrates the locations of magnets 1503 within the magnetron. These magnets are positioned in a groove 1504 machined into the bottom of outer pole piece 1502. The primary purpose of the groove is to assure that the tops of the magnets are all at a uniform height. Because the pole pieces are a strongly ferromagnetic material such as magnetic grades of stainless steel, the magnetic attraction between the outer pole piece 1502 and magnets 1503 bond the magnets quite rigidly to the bottom of this groove. However, as illustrated in Figure 15C, to ensure centering of the magnets within the outer pole piece when the magnetron is rotated by motor 95, incompressible, nonmagnetic material 1506 such as nylon is included between magnets 1503 and the sidewall of outer pole piece 1502 to ensure substantial lateral centering of magnets 1503 within outer pole piece 1502. It is important to center magnets 1503 between the sidewalls of outer pole piece 1502 so that the magnetic field strength is substantially constant along the entire length of trap region to produce substantially uniform ion generation within this trap region.

This particular pair of pole pieces has roughly the shape of a three. Because of the rotation of these pole pieces, a bridge 1507 is included between the tips of the letter three to provide structural strength to the outer pole piece. A plate 1508 is attached to the outer pole piece to enable mounting of this pole piece to motor mounting plate 94.

Figure 15C is a perpendicular cross-sectional view along the cut indicated in Figure 15B. This view illustrates that the outer pole piece 1502 is bowl-shaped with a rim 1509 that is substantially coplanar with an inner pole piece 1510. Between rim 1509 and inner pole piece 1510 is a gap 1505 that has a substantially constant width.

This view also illustrates the structural advantages that enable these pole pieces to provide a strong magnetic field much closer to the outer perimeter of the target. The separation between the trap region and sidewall 77 of the magnetron is on the order of the thickness of the sidewalls of outer pole piece 1502 plus about half the width of the gap 1505 between magnet 1503 and the sidewall of the outer pole piece. Since this distance is typically much less than the minimum distance D of the embodiment in Figure 9, the outermost groove can be much closer to the perimeter of the target than can be achieved by the embodiment of Figure 9.

This structural configuration also enables a greater amount of ferromagnetic material to be included in the magnetron than in the embodiment of Figure 9. This increases the magnetic field strength in the trap region, thereby increasing the effectiveness of electron trapping. This increases the electron concentration in the gap and therefore also increases the amount of ionization produced by the trapped electrons.

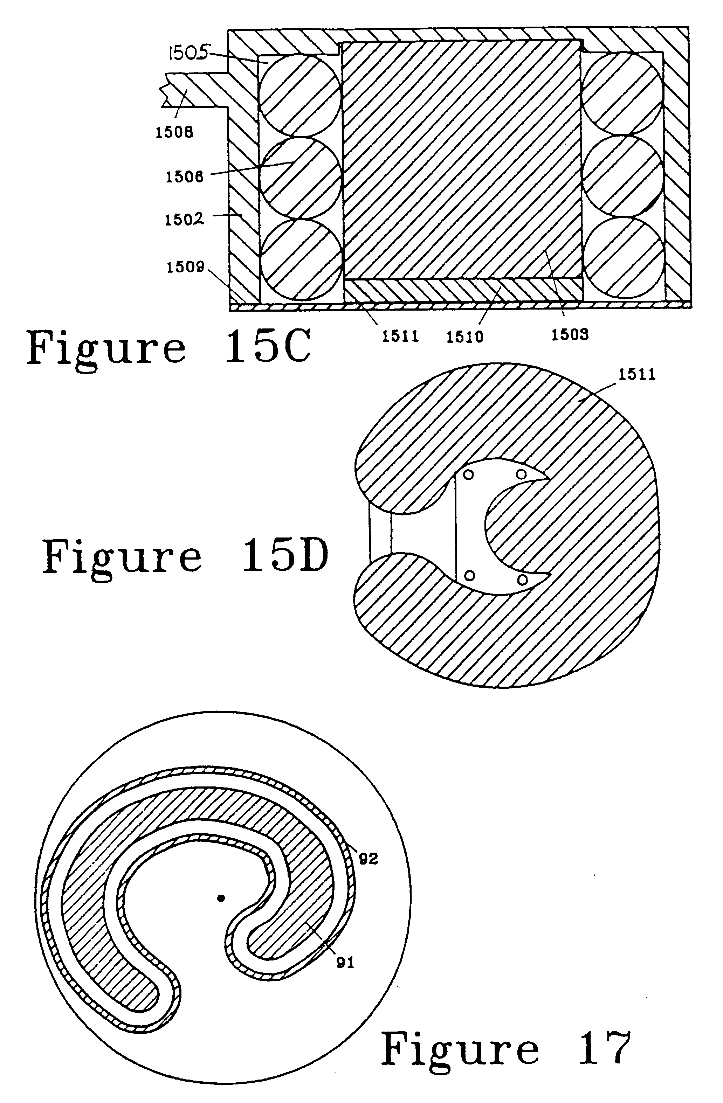

Figure 15D is a parallel cross-sectional view that passes through a cover plate 1511. The cavity within which the pole pieces rotate is typically filled with water to facilitate thermal transfer from the target through the backing plate into the cooling water. Because the magnets would be corroded by such water, it is important to provide a water-tight environment for the magnets. This is achieved by attaching a cover plate 1511 onto the top edge of the sidewalls of the outer pole piece. A ferromagnetic grade of stainless steel is used for the outer pole piece and a nonmagnetic grade of stainless steel is used for the faceplate.

Each of magnets 1503 is preferably an ultra strong rare earth magnet, such as a neodymium-iron-boron magnet or a samarium-cobalt magnet, so that a particularly strong magnetic field is produced. A strong magnetic field is advantageous because it provides improved trapping of electrons, thereby improving the generation of ions in these trap regions. However, aside from the particular type of magnet utilized, a comparison of Figure 15B and 9A illustrate that a much greater number of magnets can be utilized in the embodiment of Figure 15A-15D than can be used in the embodiment of Figure 9. The bowl-shaped outer pole piece 1502 enables the use of bar magnets insted of horseshoe magnets, thereby enabling a much greater density of magnetic material between the two pole pieces.

The actual sputtering intensity profile produced by this magnetron is illustrated in Figure 16. Because the outermost peak is the deepest and because it occurs at the greatest distance from the axis of rotation, even a small amount of outward radial positioning of this peak produces a significant increase in target utilization. This can be seen by noting that the intensity profile in Figure 16 produces a 48.6% target utilization as compared to the 34.6 target utilization (illustrated in Figure 11) produced by the pole pieces of Figure 9A. This represents a 40% increase in target utilization. Target utilization represents the percentage of target material sputtered compared to the maximum amount which would be sputtered with uniform erosion.

Figures 11 and 16 present data for the case of 11.3" targets. Figure 18 illustrates the sputtering intensity profile and the target utilization that results for a 10" target for pole pieces as in the alternative embodiment illustrated in Figure 17. The 53.3% target utilization represents a 54% improvement over that in Figure 11.

Another advantage of this structural configuration is a trap region can be produced having sharper bends than can be produced by the prior embodiment of Figure 7. This enables the production of three sputtering peaks instead of the two peaks of the embodiment of Figure 9A. This also enables greater flexibility in selection of the shape of the inner pole piece.

The parallel cross-sectional shape of the pole pieces need not be in the shape of the number three. This particular shape was chosen because it produces three sputtering peaks that substantially optimize coating thickness uniformity, step coverage and step coverage uniformity. However, pursuant to the analysis presented above, the shape of the inner pole piece is selected to produce a sputtering intensity distribution that approximates the ideal distribution $S^i(r_t)$ presented in Figures 8A and 8B.

The actual distribution $S^a(r_t)$ is determined by the radial distribution of the trap region. A plot of the fraction of trap region that is located at a distance $r_t$ from rotation axis A is substantially equal to $S_a(r_t)$ so that, when the pole pieces are rotated about axis A, a circularly symmetric sputter pattern is produced that is substantially equal to $S_a(r_t)$. An alternate shape for the pole pieces is illustrated in Figure 17. These pole pieces produce a gap having the shape of a pair of partial spirals that are connected together at both ends.

## Claims

1. A sputtering system for sputtering particles from a target (41) onto a wafer (42), said sputtering system comprising:

   a reactor that encloses a vacuum chamber (1001) in which said target (41) and wafer (42) are to be placed;

means (1004) for producing an electric field incident onto the target (41) to accelerate ions into the target to sputter particles from the target; and

a magnetron assembly (90) for producing a sputtering intensity distribution in said target substantially equal to an ideal sputtering intensity distribution $S_i(r_t)$, said magnetron assembly comprising:

a ferromagnetic inner pole piece (91, 1501);

a ferromagnetic outer pole piece (92, 1502), coplanar with and encircling the inner pole piece (91, 1501);

a motor (95) that rotates these pole pieces at a common rotation rate about axis A which is substantially perpendicular to a plane containing said pole pieces and on which said wafer (42) is to be centered perpendicular to this axis;

a gap (912,1505) formed between said two pole pieces, having the shape of a closed loop for which the fraction of gap at each radial distance $r_t$ from axis A is substantially equal to said ideal sputtering intensity distribution $S_i(r_t)$ in said target that produces a uniform thickness of sputtering particles on said wafer, where $r_t$ is the distance of a point on the target from axis A;

and

a magnetic field source (93, 1503) that produces a magnetic field across said gap (912, 1505) between the two pole pieces.

2. A sputtering system as in claim 1 wherein said gap (912, 1505) has a substantially constant width.

3. A sputtering system as in claim 1 or 2, wherein said pole pieces have been formed by milling into a sheet of ferromagnetic material a cut (1504) of width equal to the width of said gap (1505).

4. A sputtering system as in one of claims 1 to 3, wherein the said gap (912, 1505) intersects said rotation axis A, whereby the center of the wafer (42) is significantly sputtered.

5. A sputtering system as in one of claims 1 to 4, wherein the shape of said gap (912) consists of a plurality of arcs, preferably a set of four arcs, of substantially constant radius of curvature, connected in series to form a closed path.

6. A sputtering system as in claim 5, wherein a first of said arcs, of radius $R_1$ and arc length L, is substantially centered on axis A; and
the other arcs are within the circle of radius $R_1$ about axis A, whereby a sputtered groove is formed in the target of depth proportional to the arc length of said first arc.

7. A sputtering system as in claim 6, wherein the first arc has a center point that is offset by a distance δ that is much smaller than $R_1$, whereby this arc has points that range in distance from the axis of rotation over the range from about $R_1 - \delta$ to $R_1 + \delta$ thereby widening an associated groove formed in the target by about 2 δ.

8. A sputtering system as in one of claims 5 to 7, wherein :
each of the four arcs has an associated radius of curvature and these four radii are selected to optimize the uniformity of deposition of a sputtered coating on the wafer.

9. A sputtering system as in of the preceding claims, wherein the ratio of the target radius $R_t$ to the wafer $R_w$ is selected to optimize deposited coating thickness uniformity and/or step coverage uniformity over the wafer.

10. A sputtering system as in one of claims 1 to 9, wherein said ferromagnetic outer pole piece (1502) is bowl-shaped in cross-section and has a rim (1509) that is substantially coplanar with the inner pole piece (1501) and that encircles the inner pole piece to produce between these two pole pieces a gap.

11. A sputtering system as in claim 10, wherein the gap has the shape of a number three or of a pair of nonintersecting partial spirals that are connected at both ends of the spirals.

**12.** A sputtering system as in one of the preceding claims, wherein said means for producing a magnetic field across the gap comprises at least one rare earth magnet, whereby an increased effeciency of trapping is achieved and/ or wherein said means for producing a magnetic field across the gap comprises at least one bar magnet, whereby an increase density of magnetic material is produced in between the pole pieces.

**13.** A sputtering system as in one of claims 10 to 12, further comprising a faceplate (1511) that is attached to the outer pole piece to produce a watertight enclosure about the means (1503) for producing a magnetic field.

**Patentansprüche**

**1.** Sputtersystem zum Sputtern von Partikeln von einem Target (41) auf einen Wafer (42), wobei das Sputtersystem folgendes aufweist:

einen Reaktor, der eine Vakuumkammer (1001) einschließt, worin das Target (41) und der Wafer (42) zu positionieren sind;

ein Mittel (1004) zur Erzeugung eines elektrischen Feldes, welches auf das Target (41) trifft, um Ionen in das Target zu beschleunigen, um Partikel von dem Target zu sputtern; und

eine Magnetronanordnung (90) zur Erzeugung einer Sputterintensitätsverteilung in dem Target, die im wesentlichen einer idealen Sputterintensitätsverteilung $S_i(r_t)$ entspricht, wobei die Magnetronanordnung folgendes aufweist:

ein ferromagnetisches Innenpolstück (91, 1501);

ein ferromagnetisches Außenpolstück (92, 1502), das mit dem Innenpolstück (91, 1501) in einer Ebene liegt und dieses umschließt;

einen Motor (95), der diese Polstücke mit einer gemeinsamen Drehzahl um die Achse A dreht, welche im wesentlichen senkrecht zu einer Ebene ist, welche die Polstücke enthält, und auf denen der Wafer (42) senkrecht zu dieser Achse zu zentrieren ist;

einen Spalt (912, 1505) zwischen den beiden Polstücken in Form von einer geschlossenen Schleife, für die der Anteil des Spaltes an jedem Radialabstand $r_t$ von der Achse A im wesentlichen der idealen Sputterintensitätsverteilung $S_i(r_t)$ in dem Target entspricht, die eine gleichmäßige Dicke von Sputterpartikeln auf dem Wafer erzeugt, wobei $r_t$ der Abstand eines Punkts auf dem Target von der Achse A ist;

und

eine Magnetfeldquelle (93, 1503) zur Erzeugung eines Magnetfeldes über dem Spalt (912, 1505) zwischen den beiden Polstücken.

**2.** Sputtersystem gemäß Anspruch 1, bei dem der Spalt (912, 1505) eine im wesentlichen konstante Breite aufweist.

**3.** Sputtersystem gemäß Anspruch 1 oder 2, bei dem die Polstücke durch Fräsen eines Einschnitts (1504), dessen Breite der Breite des Spalts (1505) entspricht, in eine Schicht aus ferromagnetischem Material gebildet sind.

**4.** Sputtersystem gemäß einem der Ansprüche 1 bis 3, bei dem der Spalt (912, 1505) die Rotationsachse A schneidet, wodurch das Zentrum des Wafers (42) signifikant gesputtert ist.

**5.** Sputtersystem gemäß einem der Ansprüche 1 bis 4, bei dem die Form des Spalts (912) aus mehreren Bögen besteht, vorzugsweise einem Satz von vier Bögen, mit im wesentlichen konstantem Krümmungsradius, in Reihe miteinander verbunden, um einen geschlossenen Pfad zu bilden.

**6.** Sputtersystem gemäß Anspruch 5, bei dem ein erster der Bögen mit einem Radius $R_1$ und einer Bogenlänge L im wesentlichen auf der Achse A zentriert ist; und
die anderen Bögen innerhalb des Kreises des Radius $R_1$ um die Achse A sind, wobei eine gesputterte Rille in dem Target mit einer Tiefe proportional zu der Bogenlänge des ersten Bogens gebildet ist.

**7.** Sputtersystem gemäß Anspruch 6, bei dem der erste Bogen einen Mittelpunkt aufweist, welcher durch einen Abstand $\delta$ versetzt ist, welcher viel kleiner als $R_1$ ist, wobei dieser Bogen Punkte aufweist, welche im Abstand von der Rotationsachse über den Bereich von etwa $R_1 - \delta$ bis $R_1 + \delta$ reichen, wodurch eine zugehörige Rille in dem Target um etwa $2\delta$ ausgeweitet ist.

**8.** Sputtersystem gemäß einem der Ansprüche 5 bis 7, bei dem:
jeder der vier Bögen einen zugehörigen Krümmungsradius aufweist und diese vier Radien zur Optimierung der Gleichmäßigkeit des Aufbringens einer gesputterten Beschichtung auf den Wafer ausgewählt sind.

**9.** Sputtersystem gemäß einem der vorhergehenden Ansprüche, bei dem das Verhältnis des Targetradius $R_t$ zum Wafer $R_w$ zur Optimierung der Gleichmäßigkeit der Dicke einer aufgebrachten Beschichtung und/oder der Gleichmäßigkeit der Stufenbedeckung über den Wafer ausgewählt ist.

**10.** Sputtersystem gemäß einem der Ansprüche 1 bis 9, bei dem das ferromagnetische Außenpolstück (1502) im Querschnitt schalenförmig ist und einen Rand (1509) aufweist, welcher mit dem Innenpolstück (1501) im wesentlichen in einer Ebene liegt und das Innenpolstück einschließt, um zwischen den beiden Polstücken einen Spalt zu bilden.

**11.** Sputtersystem gemäß Anspruch 10, bei dem der Spalt die Form einer Zahl drei oder eines Paars nichtschneidender Teilspiralen aufweist, die an beiden Enden der Spiralen verbunden sind.

**12.** Sputtersystem gemäß einem der vorhergehenden Ansprüche, bei'dem das Mittel zur Erzeugung eines Magnetfeldes über dem Spalt mindestens einen Seltenerdmagneten aufweist, wodurch ein erhöhter Wirkungsgrad des Einfangens erreicht ist und/oder wobei der Spalt mindestens einen Stabmagneten aufweist, wodurch eine erhöhte Dichte von magnetischem Material zwischen den Polstücken erreicht ist.

**13.** Sputtersystem gemäß einem der Ansprüche 10 bis 12, das weiterhin eine Schutzplatte (1511) aufweist, die an dem Außenpolstück angebracht ist, um eine wasserdichte Hülle um das Mittel (1503) zur Erzeugung eines Magnetfeldes zu schaffen.

## Revendications

**1.** Système de pulvérisation pour pulvériser des particules depuis une cible (41) jusque sur une plaquette (42), ledit système de pulvérisation comprenant :

un réacteur qui renferme une chambre à vide (1001) dans laquelle ladite cible (41) et ladite plaquette (42) doivent être placées ;
des moyens (1004) pour produire un champ électrique incident sur ladite cible (41) pour accélérer des ions jusque dans la cible pour pulvériser des particules depuis la cible ; et
un ensemble à magnétron (90) pour produire une distribution de l'intensité de pulvérisation dans ladite cible sensiblement égale à une distribution de l'intensité de pulvérisation idéale $S_i(r_t)$, ledit ensemble à magnétron comprenant :

une pièce polaire intérieure ferromagnétique (91, 1501) ;
une pièce polaire extérieure ferromagnétique (92, 1502), coplanaire avec la pièce polaire intérieure (91, 1501) et l'encerclant ;
un moteur (95) qui fait tourner ces pièces polaires à une vitesse de rotation commune autour d'un axe A qui est sensiblement perpendiculaire à un plan contenant lesdites pièces polaires et sur lequel ladite plaquette (42) doit être centrée perpendiculairement audit axe ;
un interstice (912, 1505) formé entre lesdites deux pièces polaires, ledit interstice ayant la forme d'une boucle fermée, la fraction d'interstice à chaque distance radiale $r_t$ à partir de l'axe A étant sensiblement égale à ladite distribution de l'intensité de pulvérisation idéale $S_i(r_t)$ dans ladite cible qui produit une épaisseur uniforme de particules de pulvérisation sur ladite plaquette, où $r_t$ est la distance d'un point de la cible à l'axe A ;
et

une source de champ magnétique (93, 1503) qui produit un champ magnétique d'un côté à l'autre de l'interstice (912, 1505) entre les deux pièces polaires.

2. Système de pulvérisation selon la revendication 1, dans lequel ledit interstice (912, 1505) a une largeur sensiblement constante.

3. Système de pulvérisation selon la revendication 1 ou 2, dans lequel lesdites pièces polaires ont été formées par fraisage, dans une feuille de matériau ferromagnétique, d'une, découpe (1504) ayant une largeur égale à la largeur dudit interstice (1505).

4. Système de pulvérisation selon l'une des revendications 1 à 3, dans lequel ledit interstice (912, 1505) intersecte ledit axe de rotation A, grâce à quoi le centre de la plaquette (42) est significativement pulvérisé.

5. Système de pulvérisation selon l'une des revendications 1 à 4, dans lequel la forme dudit interstice (912) consiste en une pluralité d'arcs, de préférence un jeu de quatre arcs, d'un rayon de courbure sensiblement constant, connectés en série pour former une voie fermée.

6. Système de pulvérisation selon la revendication 5, dans lequel un premier desdits arcs, de rayon $R_1$ et de longueur d'arc L, est sensiblement centré sur l'axe A ; et
les autres arcs sont inclus dans le cercle de rayon $R_1$ autour de l'axe A, grâce à quoi une rainure pulvérisée est formée dans la cible d'une profondeur proportionnelle à la longueur d'arc dudit premier arc.

7. Système de pulvérisation selon la revendication 6, dans lequel le premier arc a un point central qui est décalé d'une distance $\delta$ de beaucoup inférieure à $R_1$, grâce à quoi cet arc comporte des points dont la distance, depuis l'axe de rotation, est comprise dans la gamme allant d'environ $R_1 - \delta$ à $R_1 + \delta$, élargissant ainsi d'environ $2\delta$ une rainure associée formée dans la cible.

8. Système de pulvérisation selon l'une des revendications 5 à 7, dans lequel chacun des quatre arcs a un rayon de courbure associé et ces quatre rayons sont choisis pour optimiser l'uniformité de dépôt d'un revêtement pulvérisé sur la plaquette.

9. Système de pulvérisation selon l'une des revendications précédentes, dans lequel le rapport entre le rayon de la cible $R_t$ à la plaquette $R_w$ est choisi pour optimiser l'uniformité d'épaisseur du revêtement déposé et/ou l'uniformité du recouvrement étagé sur la plaquette.

10. Système de pulvérisation selon l'une des revendications 1 à 9, dans lequel ladite pièce polaire extérieure ferromagnétique (1502) a, en coupe transversale, une forme en bol et elle comporte un pourtour (1509) qui est sensiblement coplanaire avec la pièce polaire intérieure (1501) et qui encercle la pièce polaire intérieure pour produire un interstice entre ces deux pièces polaires.

11. Système de pulvérisation selon la revendication 10, dans lequel l'interstice a la forme du nombre trois ou d'une paire de spirales partielles non sécantes qui sont connectées aux deux extrémités des spirales.

12. Système de pulvérisation selon l'une des revendications précédentes, dans lequel lesdits moyens de production d'un champ magnétique d'un côté à l'autre de l'interstice comprennent au moins un aimant de terre rare, grâce à quoi on obtient une efficacité accrue du piégeage et/ou dans lequel lesdits moyens de production d'un champ magnétique d'un côté à l'autre de l'interstice comprennent au moins un barreau magnétique, grâce à quoi une densité accrue de matériau magnétique est produite entre les pièces polaires.

13. Système de pulvérisation selon l'une des revendications 10 à 12, comprenant en outre une plaque de façade (1511) qui est fixée à la pièce polaire extérieure pour produire une enceinte étanche à l'eau autour des moyens (1503) de production d'un champ magnétique.

Figure 1A
(Prior Art)

Figure 1B
(Prior Art)

Figure 2 (Prior Art)

*Fig. 3*

*Fig. 4*

Figure 5

Figure 6

Figure 7

Figure 8A

Figure 8B

9B

*Fig. 9A*

99 1208

93

93

R1

A 91

910

D

912

911

92

9B

90

*Fig. 9B*

94

MOTOR 95

93

93

911

9A

96 9A

9A

41 96 97 96 *92*

1006

1005

*Fig. 10*

TO LID

1007

1001

42

1002

1004

1003

Figure 11

Figure 16

Figure 18

Figure 12A

Figure 12B

Figure 12C

Figure 13

Figure 14

Figure 15A

Figure 15B

1505

1508

1506

1502

1509

## Figure 15C

1511 1510 1503

1511

## Figure 15D

92

91

## Figure 17